Europäisches Patentamt

(19) European Patent Office

Office européen des brevets

(11) **EP 0 805 483 A1**

(12) **EUROPEAN PATENT APPLICATION**
published in accordance with Art. 158(3) EPC

(43) Date of publication:
05.11.1997 Bulletin 1997/45

(51) Int. Cl.$^6$: **H01L 21/302**

(86) International application number:
PCT/JP96/03013

(21) Application number: 96935355.6

(22) Date of filing: 17.10.1996

(87) International publication number:
WO 97/15073 (24.04.1997 Gazette 1997/18)

(84) Designated Contracting States:
DE FR GB IT NL

(30) Priority: 17.10.1995 JP 293256/95
09.05.1996 JP 137736/96
15.05.1996 JP 143432/96

(71) Applicant: ASM JAPAN K.K.
Tokyo 206 (JP)

(72) Inventors:
• SHIMIZU, Akira
Tama-shi, Tokyo 206 (JP)
• HU, Peirong
Tama-shi, Tokyo 206 (JP)

• MIYAKAWA, Hitoshi,
ASM Japan K.K.,
Nagaoka Factory
Santou-gun, Niigata-prefecture 940-23 (JP)
• TANABE, Nobuaki,
ASM Japan K.K.,
Nagaoka Factory
Santou-gun, Niigata prefecture 940-23 (JP)

(74) Representative:
de Bruijn, Leendert C. et al
Nederlandsch Octrooibureau
P.O. Box 29720
2502 LS Den Haag (NL)

(54) **SEMICONDUCTOR TREATMENT APPARATUS**

(57) An apparatus having a simplified structure for uniformly etching a wafer without requiring additional apparatuses, comprising a reaction chamber, at least one injector for emitting an etching gas to the wafer in parallel thereto inside the reaction chamber, a boat for storing semiconductor wafers with a predetermined pitch, a drive mechanism for rotating the boat on its center axis, and a seal for isolating the drive mechanism from the reaction chamber. The injector emits etching gas at a high pressure against the wafers rotating at a high speed in the reaction chamber evacuated to vacuum. The etching gas is uniformly distributed on the surface of the wafers rotating at a high speed, and the wafers are uniformly etched. The problem of contamination does not occur because the interior of the reaction chamber is completely enclosed by the movable seal during the rotation of the wafers. Further, the support boat does not vibrate even at a high rotating speed because the center of gravity coincides with the axis of rotation.

FIG.1

## Description

### Technical Field

The present invention relates generally to a semiconductor wafer etching device, and in particular to an etching device for rotation processing wafers in a reaction chamber.

### Background Art

In the prior art, wet etching and dry etching have been used as etching methods for etching oxide films or the like on the surface of a semiconductor wafer. With the recent integration trend of devices, the dry etching method has come to be given the most attention.

The conventional vapor phase HF etching method utilizes a mixed gas of HF and $H_2O$ as the etching gas and removes a natural oxide film by means of the following reaction formula. Here, $H_2O$ serves as a catalyst.

$$4HF + SiO_2 \rightarrow SiF_4 + 2H_2O \qquad (1)$$

At such a time it has been necessary to maintain the consistency of the $HF/S_2O$ density in order to guarantee the uniformity of etching on the wafer, and this has necessitated a large discharge of $H_2O$ gas. Consequently, firstly an evaporation tank having a large surface area is required, and a method known as flip-flop which switches between an etching gas inlet and waste outlet must be used, for which purpose additional devices are required. Thus, in conventional oxide film dry etching there has been the disadvantage that the overall apparatus is extremely complicated and large expensive.

On the other hand, the conventional selective etching method selectively etches only those portions of silicon oxide films (either PSG or BPSG) which have been doped with phosphorus or phosphorus and boron, and retains the other portions of the non-doped silicon oxide film (NSG).

PSG or BPSG are selectively etched as follows. In an initial step of etching using only HF as the etching gas, the above chemical reaction (1) is produced on all of the PSG, BPSG and NSG oxide films, with minute amounts of water within those oxide films which serve as a catalyst, thereby etching the oxide films. However, because this reaction is executed under reduced pressure, the water produced by the above chemical reaction (1) is vaporized on the NSG film and etching does not proceed beyond that point. On the other hand, on the PSG and BPSG films the water produced by the reaction (1) causes the following chemical reaction (2) with the phosphorus oxide within the PSG and BPSG films, forming phosphoric acid.

$$P_2O_5 + 3H_2O \rightarrow 2H_3PO_4 \qquad (2)$$

Because the vapor pressure of phosphoric acid is low, it does not evaporate under reduced pressure and results in a layer on the PSG and BPSG films. HF as the etching gas is incorporated in the phosphoric acid and ionized, then again causes the above chemical reaction (1), so that they etch the PSG or BPSG film at high speed.

However, actually, even after the etching gas is exhausted, non-ionized HF remains within the phosphoric acid residing on the semiconductor wafer. When the semiconductor wafer is unloaded from the reaction chamber, the HF within the phosphoric acid reacts with water vapor within the atmosphere and is ionized, whereupon the NSG remaining without being etched causes the above chemical reactions and is thereby etched. In order to prevent this, the phosphoric acid must be quickly and completely washed off using purified water after the selective etching is completed.

In a conventional load-lock type device, quickly washing and rapidly drying the wafers every time is basically troublesome and if one attempts to improve this situation there are some disadvantages that the number of steps increases, peripheral devices are required and yield is reduced.

Further, in the prior art, because the processes in the above natural oxide film etching and selective etching differ, different devices are required for each process, therefore the problems of space and cost cannot be prevented.

On the other hand, a conventional semiconductor wafer washing device employs a spin-dry method which scatters water droplets by means of centrifugal force by rotating the wafer. However, with this method there is the problem that the wafer is contaminated by dust produced by the friction in the rotating portion. Also, with conventional devices there is the disadvantage that a magnetic seal which generates very little dust cannot be used as a sealing member due to the problem of corrosion resistance against etching.

Further, because precise adjustment of the balance of the support boat for supporting the wafers has been necessary for high speed rotation of the wafers in the prior art, operating performance is low and this leads to reduction in throughput.

Therefore, the object of the present invention is to provide a semiconductor processing device in which etching, washing and drying can be performed by a single device.

Also, another object of the present invention is to provide a device for uniformly etching all portions on the wafer.

Further, another object of the present invention is to provide an etching device and method for greatly reducing the number of steps and improving yield.

Further still, another object of the present invention is to provide a seal mechanism by which the semiconductor wafer is not contaminated by dust generated from the rotating portions or dust from outside the reaction chamber in all processes during execution of dry-wet-dry etching.

Further yet, another object of the present invention is to provide a support boat which has no need to adjust balance adjustment with respect to high speed rotation of semiconductor wafers.

Disclosure of Invention

In order to achieve the above objects, the apparatus for processing semiconductor wafers, comprises: a reaction chamber which is exhausted and maintained substantially a vacuum state; at least one injector means, within said reaction chamber for spraying a gas or liquid flow uniformly and in parallel onto surfaces to be processed of said semiconductor wafers; and a rotation mechanism outside said reaction chamber for rotating said semiconductor wafers.

The injector means of the aforementioned apparatus preferably comprises one injector means for reaction gas for processing and another injector means for a gas or liquid for washing or purging.

Further, the aforementioned apparatus can comprise elevator means for vertically moving said semiconductor wafers to transport them into and out of said reaction chamber.

Furthermore, the aforementioned apparatus can comprise a bellows means for maintaining airtightness of said reaction chamber during vertical movement of said semiconductor wafers, the bellows means being hermetically connected to said reaction chamber at one end, mechanically connected to said elevator means at another end, and freely vertically expandable and compressible together with vertical movement of said semiconductor wafers.

Meanwhile, a apparatus for rotating to process semiconductor wafers in a reaction chamber, comprises: a sealing mechanism disposed between a source of a rotation force and a rotating means for isolating the interior of the reaction chamber from the outside, wherein said sealing mechanism includes a movable seal means which works as a non-contact seal when the rotating means is rotating or which works as a contact seal when the rotating means is stationary.

Also, the movable seal means of the sealing mechanism of the aforementioned apparatus specifically comprises a annular seal surface and a annular double bellows member which rises and falls by means of air pressure.

Further, the seal mechanism of the aforementioned apparatus comprises a magnetic seal means, and a space between said movable seal means and said magnetic seal means is evacuated.

Meanwhile, the apparatus of the present invention for rotating to process semiconductor wafers in a reaction chamber, comprises: a wafer support boat having at least one removable support member for mounting semiconductor wafers, wherein the support member has a symmetrical shape with respect to a plane including an axis of rotation, the axis of rotation passing through a center of gravity of the support boat on which the semiconductor wafers are mounted.

Also, the support member of the wafer support boat of aforementioned apparatus has at least one wafer support blade which is provided along the peripheral edges of the semiconductor wafers in symmetrical relation with respect to said plane.

Brief Description of Drawings

Fig. 1 is a cross-sectional drawing of a preferred embodiment of the semiconductor processing apparatus of the present invention.

Fig. 2 shows cross-sectional drawings of another embodiment of the semiconductor processing apparatus of the present invention.

Fig. 3 is an enlarged cross-sectional drawing of a preferred embodiment of a seal means of the present invention.

Fig. 4 shows the seal means of Fig. 3 during rotation.

Fig. 5 is a preferred embodiment of a wafer support boat of the present invention.

Fig. 6 shows embodiments of a support member of the support boat shown in Fig. 5.

Best Mode for Carrying Out the Invention

The present invention will be described below together with the drawings.

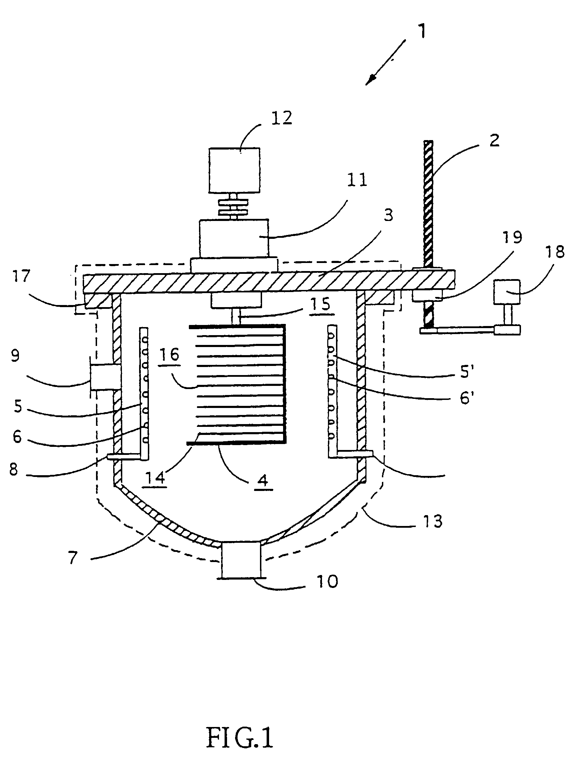

Fig. 1 shows in brief a cross-sectional drawing of a preferred embodiment according to the present invention. The vapor phase etching device 1 according to the present invention is a stand-alone type etching device and generally comprises a vertical reaction chamber 7 made of Teflon-coated SUS or nickel-based anticorrosive alloy, injector means 5 and 5' comprising a cylindrical tube having a plurality of holes 6 and 6', a support boat 4 for mounting a plurality of semiconductor wafers 14 by stacking them vertically at constant intervals, a rotation mechanism 12 located outside the reaction chamber for rotating the support boat 4 around its central axis, seal means 11 for isolating the rotation mechanism 12 from the inside of the reaction chamber, and elevator means 2 and 3 for closing and opening the reaction chamber 7 as well as moving the support boat 4 upward and downward.

Further, the etching device 1 according to the present invention has a water outlet 10 for draining purified water for washing and a gas outlet 9 for exhausting etching gases and drying gases such as HF $H_2O$ and $N_2$ etc., provided separately. Also, the reaction chamber 7 is completely covered by a silicon rubber heater 13.

In the interior of the reaction chamber, two injector means 5 and 5' are installed parallel to the central axis of the support boat so as to be substantially opposite each other. The injector means 5 and 5' are thin cylindrical tube of the same shape. A plurality of holes 6 and 6' are perpendicularly provided at constant intervals in the side surfaces of these cylindrical tube. The diameters of the holes are 0.5 to 4 mm and the gaps therebetween are 4 to 20 mm. Also, the arrangement of the holes may be arbitrarily selectable. The gaps between the holes are preferably equal to the gaps between the semiconductor wafers 14 on the support boat 4 so that an etching gas injected from the injector means is sprayed horizontally onto the surfaces of the wafers. The injector means 5 is used exclusively for the etching gas, and is connected to an external reaction gas tank through a port 8. In the case of natural oxide film etching a mixed gas of HF gas and $H_2O$ is used as the etching gas, while in the case of selective etching only HF gas is used. Meanwhile, the injector means 5' is used exclusively for a washing liquid and a drying gas, and is connected to external gas and liquid tanks via a port 8'. Generally, purified water is used as the washing liquid and $N_2$ is used as the drying gas. The above two injector means can each be comprised of a plurality of injector means, or can be unified into a single injector means.

As described in detail below, the support boat 4 has support members 16 on which the semiconductor wafers 14 are mounted by stacking them vertically in parallel at constant intervals of 4 to 20 mm. One end of a rotation shaft 15 is coupled to the upper end face of the support boat 4 and transmits rotating power from an external electric motor means 12 to the support boat 4.

The above rotation mechanism comprises the electric motor 12 for generating rotating power which is completely isolated outside the reaction chamber 7 and the rotation shaft 15 for transmitting the rotating power to the support boat 4. One end of the rotation shaft is coupled to the upper end of the support boat, while the other end is operably connected to the electric motor 12. The rotation shaft 15 is completely sealed by the seal means 11 described in detail below to maintain the airtightness of the reaction chamber. The electric motor 12 is disposed outside the reaction chamber so that there is no danger of contamination. The revolutions of the support boat 4 are normally 1 to 3,000 rpm, and are selectable by adjusting the revolutions of the electric motor according to the diameter of the wafers and the pressure of the etching gas.

The above elevator means comprises a ball screw 2 and a cover means 3 which moves in engagement with the ball screw 2. The cover means 3 axially supports the shaft 15 via the seal means 11 in substantially the center thereof. A flange 17, in order to keep the interior of the reaction chamber in an airtight state, engages with the lower face of the cover means 3 at the same time that the cover means 3 is lowered. The rotating power of an external electric motor 18 is converted to vertical movement along the ball screw 2 by a conversion member 19 to raise and lower the cover means 3. In a state where the cover means 3 is fully lowered the reaction chamber 7 is maintained in a completely airtight state and the etching process is initiated. Also, in a state where the cover means 3 is fully raised inward conveying and outward conveying of the wafers can be executed.

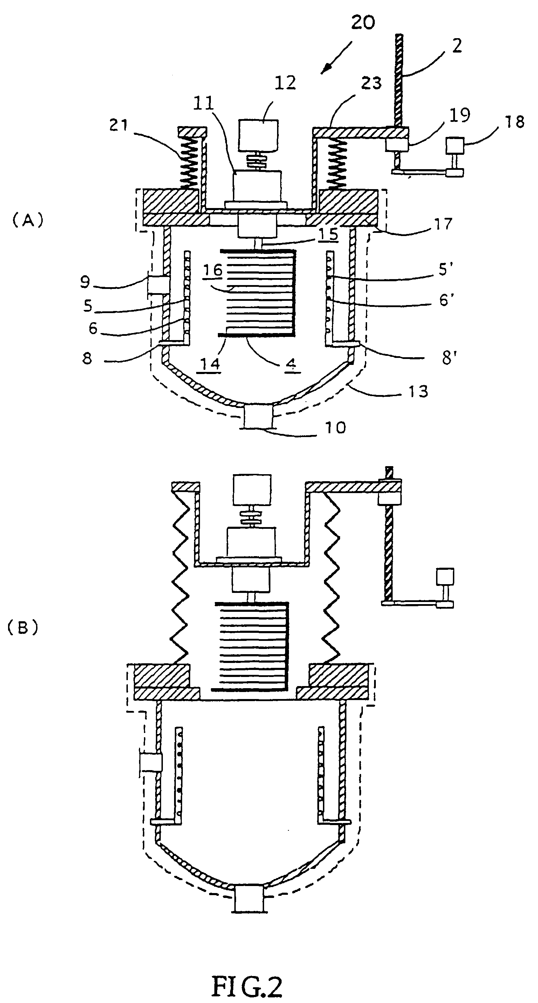

Fig. 2 shows in brief cross-sectional drawings of a second embodiment according to the present invention. Fig. 2(A) shows a state during etching processing and Fig. 2(B) shows a state when the wafers are being conveyed inward and conveyed outward. Here the same means as are in the embodiment of Fig. 1 are indicated by the same reference numbers. Those points in the second embodiment which differ from the preferred embodiment of Fig. 1 are the shape of the cover means 23 and the existence of a bellows means 21.

In Fig. 2(A), the cover means 23 comprises a flat lower surface, a cylindrical side surface, and a flange portion which has been drawn outward from an upper opening end. The lower surface of this cover means 23 engages with the flange 17 of the reaction chamber 7 and completely maintains the airtightness of the reaction chamber 7 via the seal means 11. Between the lower end portion of the flange of the above cover means 23 and the upper end portion of the flange 17 of the reaction chamber 7 is attached a compressible/extendable accordion-shaped bellows means 21. As shown in Fig. 2(B), the bellows means extends and compresses according to the rise and fall of the support boat, whereby the wafers are not exposed to the outside and are protected from contamination even when they are conveyed inward and outward.

The seal means 11 has a movable seal means which is explained in detail below. By means of this movable seal means, complete sealing is achieved when the semiconductor wafers are rotating and stationary, and in all of the processes in dry-wet-dry etching contamination by dust generated by the friction of the rotating shaft and dust from outside the reaction chamber can be completely prevented.

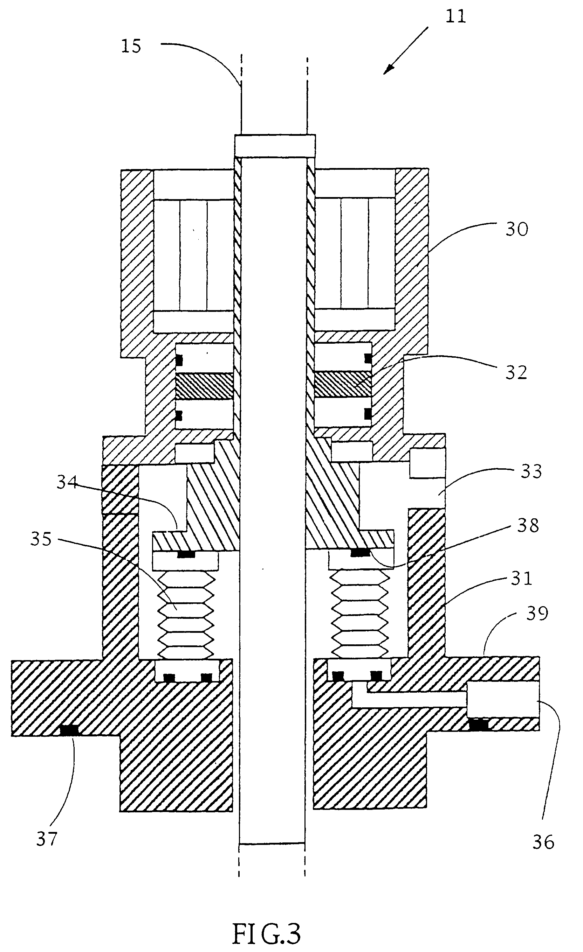

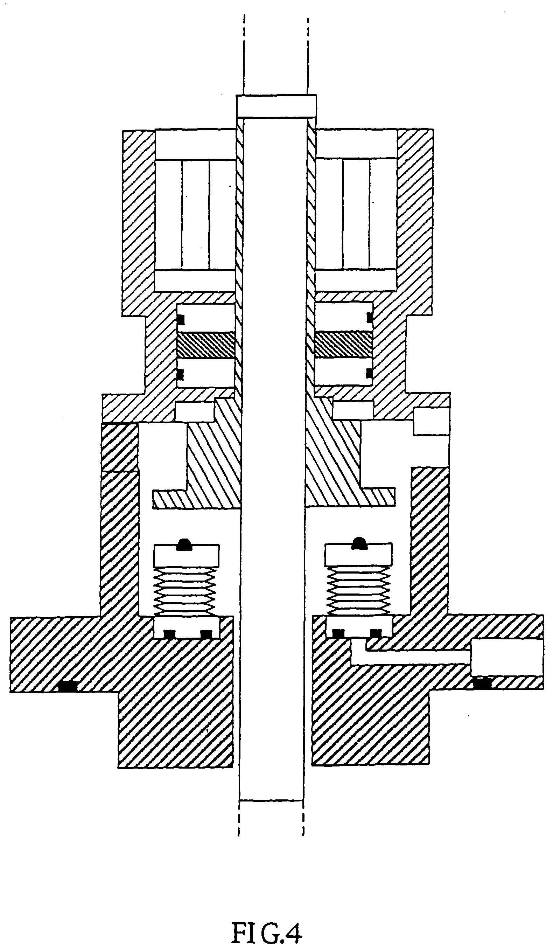

Fig. 3 is an enlarged cross-sectional drawing of the seal means of the semiconductor processing device according to the present invention. The seal means 11 of the present invention comprises a bearing box 30, a magnetic seal 32, a movable type bellows seal 35 and a housing 31 which encloses them. The movable type bellows seal 35 comprises an annular seal face 38 and an annular double bellows member 35 for supporting it. The interior of the bellows communicates with a port 36 provided on the side face of the housing, and it is possible to adjust the height of the seal face 38 and its sealing pressure with the end face of a flange 34 (refer to Fig. 4) by changing inner pressure of the bellows. In the side face of the housing is provided a port 33 for creating a vacuum in the space between the magnetic seal 32 inside the housing and the movable type bellows seal 35. The cover means 3 and seal means 11 of Fig. 1 are engaged by a flange 39 and sealed by the seal face 37. The rotation shaft 15, seal face 38 of the bellows and periphery of the engaging portion of the housing are made from a nickel-based anticorrosive alloy.

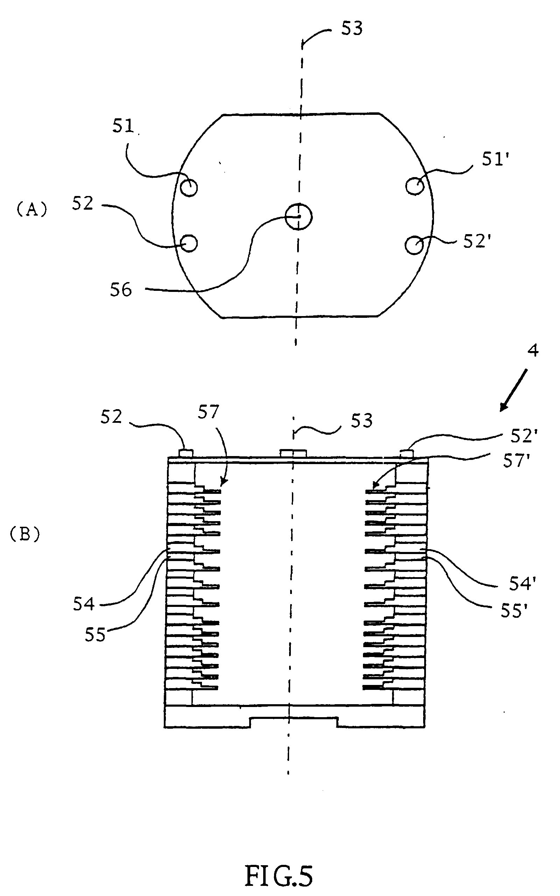

Fig. 5 shows a preferred embodiment of the wafer support boat of the present invention. (A) is a plan view of the support boat 4, and (B) shows a side view thereof. An anticorrosive material is used in the support boat 4 so that corrosion of the wafer support boat during processing is prevented.

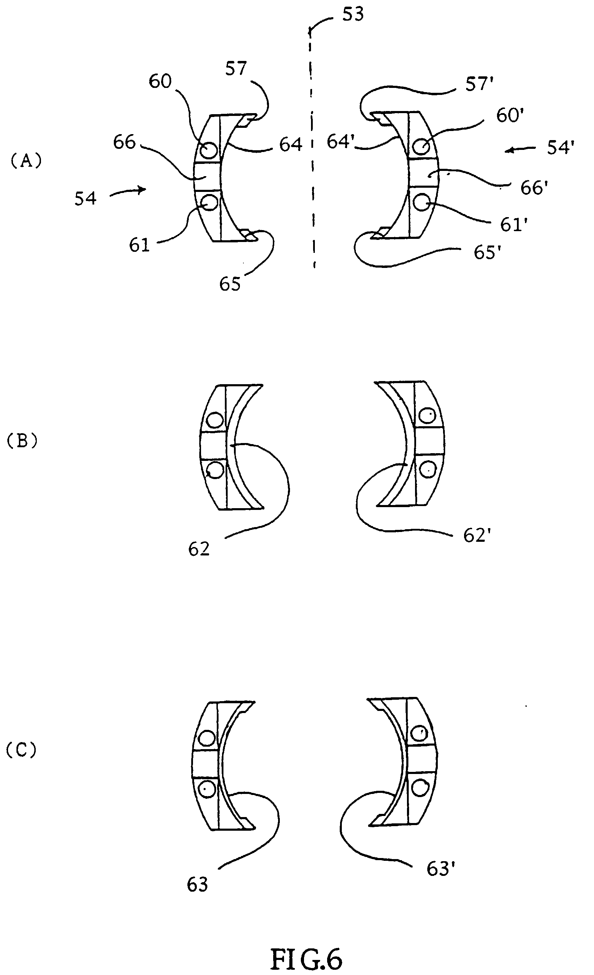

The support members for mounting the semiconductor wafers, as shown in Fig. 5(B), comprise first support members 54 and second support members 54', these first and second support members 54 and 54' being detachably arranged facing each other in the support boat 4. In each of the first and second support members 54 and 54' support plates 57 and 57' are provided to support the semiconductor wafers. The first and second support members 54 and 54' have the same shape and are arranged facing each other in a mirror image relationship with respect to a plane 53 passing through a rotation shaft 56 and perpendicular to the upper end face of the support boat 4. The support members 54 and 54' have through holes (60, 61, 60' and 61' in Fig. 6) of similar shape to the cross-sectional shapes of posts 51, 52, 51' and 52', and are detachably arranged in the wafer boat by means thereof. Spacers 55 and 55' having though holes (not shown in the drawings) of the same diameter as the above through holes are layered together with the support members 54 and 54' through the posts, whereby the number of support members 54 and 54' arranged in the support boat 4 and the gaps between each of the support members can be suitably selected.

According to the support boat 4 of the present invention, troublesome adjustment of the rotation balance as in the prior art is unnecessary.

For example, where 25 pieces of eight inch silicon wafers having orientation flats are mounted in a support boat, according to calculations the orientation flats side would only be 7.25g lighter, as a result the center of gravity of the entire support boat would shift in the opposite direction to the orientation flats by only 0.55 mm from the centers of the semiconductor wafers. According to the support boat of the present invention, the problem concerning orientation flats can be solved by merely displacing the support boat such that the position of the center of rotation is preliminary shifted by 0.55 mm, because other factors which concern the shift of the center of gravity are suppressed to minimum.

While exactly the position of the center of gravity of the wafers may be shifted only a little from the axis of rotation because of either a idle of the support member 54 and 54' or a clearance between the wafer and blade member 57 and 57', all of 25 pieces of the wafers would not he shifted in the same direction so that overall shift of displacements would be canceled each other.

Further, with the support members 54 and 54', an abrasion-resistant engineering plastic such as a nickel-based anticorrosive alloy or Vesper (a trade mark) (produced by Du Pont) can be used.

In this manner, in a state where the semiconductor wafers are mounted on the first and second support members 54 and 54', by setting the center of gravity of the support boat 4 so that it exists on the rotation shaft 56, problems such as vibration of the support boat during rotation and the semiconductor wafers flying off due to centrifugal force are eliminated.

Figs. 6(A), (B) and (C) show embodiments of the support members of the support boat according to the present invention. The first and second support members 54 and 54' have shapes which are mirror images of each other with respect to the aforementioned plane 53. In these support members 54 and 54', the blade members 57 and 57' made from a nickel-based anticorrosive alloy or abrasion-resistant engineering plastic are provided facing each other. As shown in the drawing, the first and second support members 54 and 54' comprise inner portions 64 and 64' having arced shapes along the periphery of the semiconductor wafers, stepped portions 65 and 65' whose thickness is substantially equal to that of the semiconductor wafers, blade members 57 and 57' provided extending inward from the lower end of the stepped portion 65 for supporting the semiconductor wafers, through holes 60, 61, 60' and 61' having similar shapes to the cross-sectional shapes of posts provided in the support boat 4, and through channels 66 and 66' having substantially the same height as the surfaces of the mounted semiconductor wafers and provided in substantially the centers of the support members 54 and 54'.

The blade members 57 and 57' for mounting the semiconductor wafers preferably have a plurality of nail shapes as shown in Fig.6(A). As shown in Fig.6(B), they may have the shapes 62 and 62' extending from the lower end of the stepped portions 65 and 65' along the inner portions 64 and 64'. Further, as shown in Fig.6(C), they may also have shapes 63 and 63' which incorporate (A) with (B).

Next, the method of etching the wafers using the above etching device according to the present invention will be explained.

First, the dry-wet-dry form of etching method will be explained.

In an etching process, first of all, a semiconductor wafer 14 is loaded to the support boat 4 and, thereafter, the elevating means 2 is actuated to transport the wafer into the reaction chamber 7. Next, the reaction chamber 7 is evacuated, and the etching gas HF or HF+$H_2O$ [HF:$H_2O$ = (99.999 % to 0.001 %);(0.001 % to 99.999 %)] is introduced into the reaction chamber 7 from the injector means 5. At this time, the pressure inside the reaction chamber 7 is maintained at 5 to 80000 Pa and preferably at 10 to 13300 Pa. During this step, the pressure of the movable bellows seal 35 of the sealing means 11 is adjusted such that the sealing surface 38 is entirely in contact with the end face of flange 34 as shown in Fig. 3 (see Fig. 3). The movable bellows seal 35 achieves perfect sealing in combination with the magnetic seal 32 provided for preventing entrainment of the atmosphere during rotation. In order to enhance the sealing effect further, the space between the magnetic seal and the movable bellows seal 35 may be also evacuated. This makes it possible to prevent generation of even a microscopic amount of dust from the magnetic seal completely.

When etching is completed, a purge gas (preferable $N_2$) is injected by the injector means 5 to exhaust the etching gas in the reaction chamber completely, thereby the atmospheric pressure is restored in the chamber. In this state, another injector means 5' injects pure water for cleaning a wafer toward the wafers 14 mounted on the boat means 4. The pure water for cleaning may be used after adding alcohol or the like thereto to reduce the surface tension thereof. At the same time when the atmospheric pressure is restored in the reaction chamber, the pressure of the movable bellows seal 35 of the sealing means 11 is adjusted such that the sealing surface 38 leaves the end face of the flange 34 and get into a non-contact state (see Fig. 4). After the movable bellows seal 35 is brought into the non-contact state, the semiconductor wafers 14 are washed by the pure water injected from the above-described injector 5' while the support boat 4 is rotated at 1 to 1000 rpm by the motor 12. The interior of the sealing means 11 is evacuated also during the cleaning step to prevent generation of a microscopic amount of dust from the magnetic seal 32 completely. Since only $N_2$ gas exists in the reaction chamber at the cleaning step, there is no possibility of corrosion and the magnetic seal 32 can be used alone.

Finally, $N_2$ gas for drying is injected again from the above-described injector means 5' toward the semiconductor wafers at a drying step. Throughout the drying step, a whole of the reaction chamber 7 is heated by the silicon rubber heater 13. Preferably, the $N_2$ gas for drying is also used after preheating. Drying is implemented at a reduced pressure while evacuating the interior of the reaction chamber. The movable bellows seal 35 is kept in the non-contact state. Drying is implemented while rotating the support boat 4 at 500 to 2000 rpm by the motor 12. After drying is finished, the elevating means 2 is actuated to transport the semiconductor wafers 14 mounted on the support boat 4 out of the reaction chamber 7.

Next, the second method of etching the natural oxide film of the wafers comprises the steps of exhausting the reaction chamber 7 to maintain substantially a vacuum state, rotating the support boat 4 for a constant time and at a constant speed while spraying an etching gas from the injector means 5 onto the wafers 14 mounted on the support members 16 of the support boat 4, and exhausting the reaction chamber 7 again. In etching the natural oxide film, the etching gas is preferably a mixed gas of HF and $H_2O$. Since the etching gas is injected horizontally at high pressure from the injector means 5 onto the wafers 14 which are rotating at 1 to 3,000 rpm, the etching gas is sprayed over the entire wafer uniformly so that the wafers are uniformly etched. The etching gas whose reaction has finished is exhausted from the gas outlet 9 and there is no re-adhesion of particles. Preferably, injection of the etching gas from the injector means 5 and exhausting of the gas from the gas outlet 9 are performed simultaneously.

In conventional devices, there was the problem that the density of the etching gas significantly differed between the vicinity of the injection inlet and the vicinity of the gas outlet depending on the location on the wafer. Because a large amount of $H_2O$ gas has been required in order to uniform the density of the etching gas, additional devices and additional steps have been necessary. By means of the device and method according to the present invention, all of these problems are solved and it has become possible to perform uniform etching of wafers in a device whose structure is simple and that requires no additional devices.

Further, a third method of selectively etching the wafers comprises the steps of exhausting the reaction chamber 7 to maintain substantially a vacuum state, spraying an etching gas from at least one injector means 5 onto the wafers 14 mounted on the support members 16 of the support boat 4, rotating the support boat 4 for a constant time and at a constant speed while spraying a washing liquid at high pressure onto the wafers 14 from at least one other injector means 5', and rotating the support boat 4 for a constant time and at a constant speed while spraying a gas onto the wafers 14 from the injector means 5' which sprayed the washing liquid in order to dry the wafers 14. In selective etching, the etching gas is HF only. Generally, purified water is used as the washing liquid and $N_2$ gas is used as the drying gas. What differs from the natural oxide film etching method is that the support boat is not rotated when the etching gas is sprayed from the injector means and that the selective etching method includes a step of washing off the HF within the remaining phosphoric acid and a step of drying the wafers. In the case of selective etching, because the wafers 14 are uniformly etched in a state where the etching gas HF injected from the injector means 5 is equilibrium condition throughout the reaction chamber, there is no necessity to rotate the support boat 4. By spraying purified water at high pressure from the injector means 5' onto the surfaces of the wafers which are rotating at high speed, high speed washing is possible. Subsequently, by rotating the wafers at high speed while injecting $N_2$ gas at high pressure from the same injector means 5', high-speed drying of the wafers 14 and the hole 6' of the injector means 5' is possible. Further, the selective etching method according to the present invention may include a step of baking the entire reaction chamber 7 at the same time as the etching step or the drying step. Thereby, the speed of the etching or drying can be further increased.

In the case of a conventional load-lock chamber, each of the process of etching, washing or drying is executed in a different apparatus. Therefore, there were many problems such that the overall structure of device complicated, the number of steps increased, and yield decreased since the wafers were coming into contact with the atmosphere and contaminated. According to the device and method of the present invention, it is possible to execute etching, washing and drying process in a single device in a short time and with high efficiency, and since the wafers do not come into contact with the outside atmosphere during the time for all processing, there is no possibility of contamination so that yield is improved.

Further, according to the semiconductor etching method of the present invention, dry-wet-dry etching can be readily executed by a single device and therefore work efficiency can be improved.

Furthermore, in all of the steps during execution of dry-wet-dry etching, contamination due to dust can be significantly suppressed. It is confirmed that while there were 1000 to 10000 in number of dust particles at 0.3 microns or more in the case of eight-inches wafers in a conventional apparatus, they were reduced to 0 to 5 in number using the device of the present invention. As a result, improvements in yield can be expected.

Further still, by means of the wafer support boat of the present invention, a balancing operation after manufacture of the support boat is unnecessary and damage to the wafers due to vibrations during rotation can be suppressed to a minimum.

**Claims**

1. An apparatus for processing semiconductor wafers, comprising:

    a reaction chamber which is exhausted and maintained substantially a vacuum state;
    at least one injector means, within said reaction chamber for spraying a gas or liquid flow uniformly and in parallel onto surfaces to be processed of said semiconductor wafers; and
    a rotation mechanism outside said reaction chamber for rotating said semiconductor wafers.

2. The apparatus of claim 1 wherein said injector means comprises one injector means for reaction gas for processing and another injector means for a gas or liquid for washing or purging.

3. The apparatus of claim 1 further comprising elevator means for vertically moving said semiconductor wafers to transport them into and out of said reaction chamber.

4. The apparatus of claim 1 further comprising a bellows means for maintaining airtightness of said reaction chamber during vertical movement of said semiconductor wafers, the bellows means being hermetically connected to said reaction chamber at one end, mechanically connected to said elevator means at another end, and freely vertically expandable and compressible together with vertical movement of said semiconductor wafers.

5. An apparatus for rotating to process semiconductor wafers in a reaction chamber, comprising:

    a sealing mechanism disposed between a source of a rotation force and a rotating means for isolating the interior of the reaction chamber from the outside,
    wherein said sealing mechanism includes a movable seal means which works as a non-contact seal when the rotating means is rotating or which works as a contact seal when the rotating means is stationary.

6. The apparatus of claim 5 wherein said movable seal means of said sealing mechanism comprises a annular seal surface and a annular double bellows member which rises and falls by means of air pressure.

7. The apparatus of claim 5 wherein said seal mechanism further comprises a magnetic seal means, and a space between said movable seal means and said magnetic seal means is evacuated.

8. An apparatus for rotating to process semiconductor wafers in a reaction chamber, comprising:

    a wafer support boat having at least one removable support member for mounting semiconductor wafers,
    wherein the support member has a symmetrical shape with respect to a plane including an axis of rotation, the axis of rotation passing through a center of gravity of the support boat on which the semiconductor wafers are mounted.

9. The apparatus of claim 8 wherein said support member of said wafer support boat has at least one wafer support blade which is provided along the peripheral edges of the semiconductor wafers in symmetrical relation with respect to said plane.

**Amended claims under Art. 19.1 PCT**

1. An apparatus for processing semiconductor wafers, comprising:

    a reaction chamber which is exhausted and maintained substantially a vacuum state;
    at least one injector means, within said reaction chamber for spraying a gas or liquid flow uniformly and in parallel onto surfaces to be processed of said semiconductor wafers; and
    a rotation mechanism outside said reaction chamber for rotating said semiconductor wafers.

2. The apparatus of claim 1 wherein said injector means comprises one injector means for reaction gas for processing and another injector means for a gas or liquid for washing or purging.

3. The apparatus of claim 1 further comprising elevator means for vertically moving said semiconductor wafers to transport them into and out of said reaction chamber.

4. The apparatus of claim 1 further comprising a bellows means for maintaining airtightness of said reaction chamber during vertical movement of said semiconductor wafers, the bellows means being hermetically connected to said reaction chamber at one end, mechanically connected to said elevator means at another end, and freely vertically expandable and compressible together with vertical movement of said semiconductor wafers.

5. (amended) An apparatus for rotating to process semiconductor wafers in a reaction chamber, comprising:

a sealing mechanism disposed between a source of a rotation force and a rotating means for isolating the interior of the reaction chamber from the outside,
wherein said sealing mechanism includes a movable seal means which works as a non-contact seal when the rotating means is rotating or which works as a contact seal when the rotating means is stationary, and said movable seal means comprises a annular seal surface and a annular double bellows member which rises and falls by means of air pressure.

6. (canceled)

7. The apparatus of claim 5 wherein said seal mechanism further comprises a magnetic seal means, and a space between said movable seal means and said magnetic seal means is evacuated.

8. An apparatus for rotating to process semiconductor wafers in a reaction chamber, comprising:

a wafer support boat having at least one removable support member for mounting semiconductor wafers,
wherein the support member has a symmetrical shape with respect to a plane including an axis of rotation, the axis of rotation passing through a center of gravity of the support boat on which the semiconductor wafers are mounted.

9. The apparatus of claim 8 wherein said support member of said wafer support boat has at least one wafer support blade which is provided along the peripheral edges of the semiconductor wafers in symmetrical relation with respect to said plane.

FIG.1

FIG.2

FIG.3

FIG.4

FIG.5

53

(A)

57
60
66
54
61
65
64

57'
60'
64'
54'
66'
61'
65'

(B)

62
62'

(C)

63
63'

# FIG.6

## INTERNATIONAL SEARCH REPORT

| International application No. |
|---|
| PCT/JP96/03013 |

| A. | CLASSIFICATION OF SUBJECT MATTER |
|---|---|

Int. Cl$^6$   H01L21/302

According to International Patent Classification (IPC) or to both national classification and IPC

| B. | FIELDS SEARCHED |
|---|---|

Minimum documentation searched (classification system followed by classification symbols)

Int. Cl$^6$   H01L21/302

Documentation searched other than minimum documentation to the extent that such documents are included in the fields searched

| Jitsuyo Shinan Koho | 1964 – 1997 |
| Kokai Jitsuyo Shinan Koho | 1971 – 1995 |
| Toroku Jitsuyo Shinan Koho | 1994 – 1997 |

Electronic data base consulted during the international search (name of data base and, where practicable, search terms used)

WPI/L

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP, 02-1121, A (Dainippon Screen Mfg. Co., Ltd.), January 5, 1990 (05. 01. 90)(Family: none) Page 3, lower right column, line 20 to page 10, lower left column, line 9 | 1, 2 |
| X | JP, 06-84864, A (Tokyo Electron, Ltd.), March 25, 1994 (25. 03. 94) & US, 5520743, A Page 2, column 2, line 31 to page 5, column 7, line 6 | 3, 4 |
| Y | JP, 01-150074, A (Nippondenso Co., Ltd.), June 13, 1989 (13. 06. 89)(Family: none) Page 4, lower left column, line 2 to page 6, upper right column, line 2 | 5, 7 |
| Y | Microfilm of the specification and drawings annexed to the written application of Japanese Utility Model Application No. 86829/1985 (Laid-open No. 203542/1986)(Mitsubishi Heavy Industries, Ltd.), | 8, 9 |

[X] Further documents are listed in the continuation of Box C.   [ ] See patent family annex.

| * | Special categories of cited documents: |
|---|---|
| "A" | document defining the general state of the art which is not considered to be of particular relevance |
| "E" | earlier document but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| January 14, 1997 (14. 01. 97) | January 28, 1997 (28. 01. 97) |

| Name and mailing address of the ISA/ | Authorized officer |
|---|---|
| Japanese Patent Office | |
| Facsimile No. | Telephone No. |

Form PCT/ISA/210 (second sheet) (July 1992)

## INTERNATIONAL SEARCH REPORT

| | International application No. |
|---|---|
| | PCT/JP96/03013 |

C (Continuation).   DOCUMENTS CONSIDERED TO BE RELEVANT

| Category* | Citation of document, with indication, where appropriate, of the relevant passages | Relevant to claim No. |
|---|---|---|
| | December 22, 1986 (22. 12. 86)(Family: none) Fig. 1; and its related explanation parts | |
| A | JP, 01-224572, A (NEC Yamaguchi K.K.), September 7, 1989 (07. 09. 89)(Family: none) Page 2, upper left column, line 19 to lower right column, line 2 | 6 |

Form PCT/ISA/210 (continuation of second sheet) (July 1992)